# EUROPÄISCHE PATENTANMELDUNG

(11) **EP 1 146 567 A1**
(43) Veröffentlichungstag der Anmeldung: **17.10.2001**
(21) Anmeldenummer: 00108252.8
(22) Anmeldetag: 14.04.2000
(51) Int. Cl.: H01L 29/868

(54) **Diode und Verfahren zu deren Herstellung**

(71) Anmelder: Infineon Technologies AG, 81669 München (DE)
(72) Erfinder: Ahrens, Carsten, 81927 München (DE); Gabl, Reinhard, 80337 München (DE); Peichl, Raimund, 85635 Höhenkirchen (DE)
(74) Vertreter: Zimmermann & Partner

(57) **Zusammenfassung**

Erfindungsgemäß wird eine Diode bereitgestellt, die zumindest einen Graben (20) in dem Halbleitersubstrat und eine Isolation (13) auf der Oberfläche des Halbleitersubstrats aufweist, so daß das Verarmungsgebiet der Diode durch den Graben und die Fläche, über welche eine Elektrode (9) direkt mit einem Diffusionsgebiet (7) der Diode in Kontakt steht, durch die Isolation (13) begrenzt ist. Die erfindungsgemäße Diode besitzt den Vorteil, daß die Ausdehnung des Verarmungsgebiets, und damit die Flächenkapazität der Diode, und die Größe der Elektrode voneinander entkoppelt sind. Die laterale Ausdehnung des Verarmungsgebiets kann unabhängig von der Größe der Elektrode (9) gewählt werden.

## Beschreibung

Die Erfindung bezieht sich auf eine Diode sowie ein Verfahren zu deren Herstellung. Die Erfindung bezieht sich insbesondere auf eine PIN-Diode. Dioden dieser Art werden beispielsweise in diskreten Schaltungen zum Schalten von Hochfrequenzsignalen eingesetzt.

Dioden werden als Gleichrichter und Schalter in vielen Bereichen der Elektronik verwendet und in unterschiedlichen Konfigurationen kommerziell angeboten. Für Anwendungen als Schalter im Hochfrequenzbereich werden Dioden mit einer niedrigen Sperrkapazität (C_{T}), bei in Rückwärtsrichtung gepolter Spannung, und einem niedrigen Flußwiderstand (r_{f} ). bei in Vorwärtsrichtung gepolter Spannung, benötigt, was zu niedriger Dämpfung in Flußrichtung und hoher Isolation in Sperrichtung führt. Ein Qualitätsmerkmal für PIN-Dioden ist das Produkt C_{T} * r_{f}.

Die Sperrkapazität einer Diode, C_{T}, setzt sich aus einer Flächenkapazität, C_{A}, und einer Randkapazität, C_{P}, zusammen. Bei großflächigen Dioden dominiert die Flächenkapazität. Sie ist bestimmt durch die Oberfläche sowie die Dicke der Verarmungsschicht der Diode, die sich bei gegebener Spannung zwischen den Gebieten unterschiedlicher Leitfähigkeit bildet. Weiterhin wird die Sperrkapazität durch das Material des Halbleitersubstrats bzw. die relative Dielektrizitätskonstante des Halbleitermaterials bestimmt. Dabei ist im Falle von Silizium die relative Dielektrizitätskonstante mit ε=12 relativ hoch.

Die Randkapazität erfaßt all die Kapazitäten einer Diode, die sich nicht der Flächenkapazität zuordnen lassen. Beispiele hierfür sind Kapazitäten, die durch die Zuleitung und Kontaktierungsflächen bestimmt sind. Die Randkapazität dominiert vor allem bei kleinflächigen Dioden.

Der Flußwiderstand kann vor allem durch kurze Wege im Halbleitersubstrat minimiert werden. Dies wird z.B. dadurch erreicht werden, daß der von der Vorderseite durch die Diffusionsschicht eintretende Strom auf der Rückseite des Halbleitersubstrates wieder heraustritt, wobei das Substrat auf der Rückseite vorher gedünnt worden ist.

Im Hochfrequenzbereich bis in den GHz-Bereich hinein haben sich die PIN-Dioden etabliert (z.B. Die Diodenfamilie BAR-63 von der Infineon Technolgies AG). Der aktive Bereich dieser Dioden besteht im wesentlichen aus drei Gebieten, einem hochdotierten Diffusiongebiet eines ersten Leitungstyps, einem quasi intrinsischen Gebiet ohne Dotierung oder nur sehr geringer Dotierung und einem hochdotierten Gebiet eines zweiten Leitungstyps. Bei diesen Dioden ist die Dicke des verarmten Gebiets im wesentlichen durch die Dicke des intrinsischen Gebiets gegeben, da das intrinsische Gebiet aufgrund der niedrigen Dotierung schon bei sehr kleinen Spannungen vollständig von freien Ladungsträgern verarmt. Durch ein relativ dickes intrinsisches Gebiet lassen sich Dioden herstellen, die schon bei kleinen Spannungen sehr niedrige Sperrkapazitäten aufweisen.

Fig. 5 zeigt einen Querschnitt durch eine rotationssymmetrische planare PIN-Diode 10 gemäß dem Stand der Technik. Gezeigt sind das Halbleitersubstrat 1, das ein p-leitendes Substratgebiet 3 und ein intrinsisches Substratgebiet 5 aufweist. Das intrinsische Substratgebiet 5 ist in der Regel durch eine undotierte bzw. nur schwach dotierte Epitaxie-schicht realisiert. Das intrinsische Gebiet 5 ist nichtleitend und wirkt daher als eine Art Dielektrikum zwischen dem n-leitenden Diffusionsgebiet 7 und dem p-leitenden Gebiet 3. Weiterhin haben die Dioden einen Rückseitenkontakt, der bevorzugt durch eine Gold-Arsen-Schicht realisiert ist, so daß die Rückseite als zweiter Kontakt der Diode dient. Um den Widerstand der Diode zu minimieren, ist die Rückseite des Halbleitersubstrats gedünnt.

Die Gesamtkapazität der Diode ist durch die Summe von Flächenkapazität C_{A} und Randkapazität C_{P} gegeben, die beide schematisch in Fig. 5 eingezeichnet sind. Ist die Diodenfläche klein so muß zunehmend der Einfluß der Randkapazität berücksichtigt werden. Die Randkapazität C_{P} in Fig. 5 ist relativ groß, da die Dielektrizitätskonstante im wesentlichen durch das verarmte Silizium vorgegeben ist, das eine hohe Dielektrizitätskonstante (ε=12) aufweist.

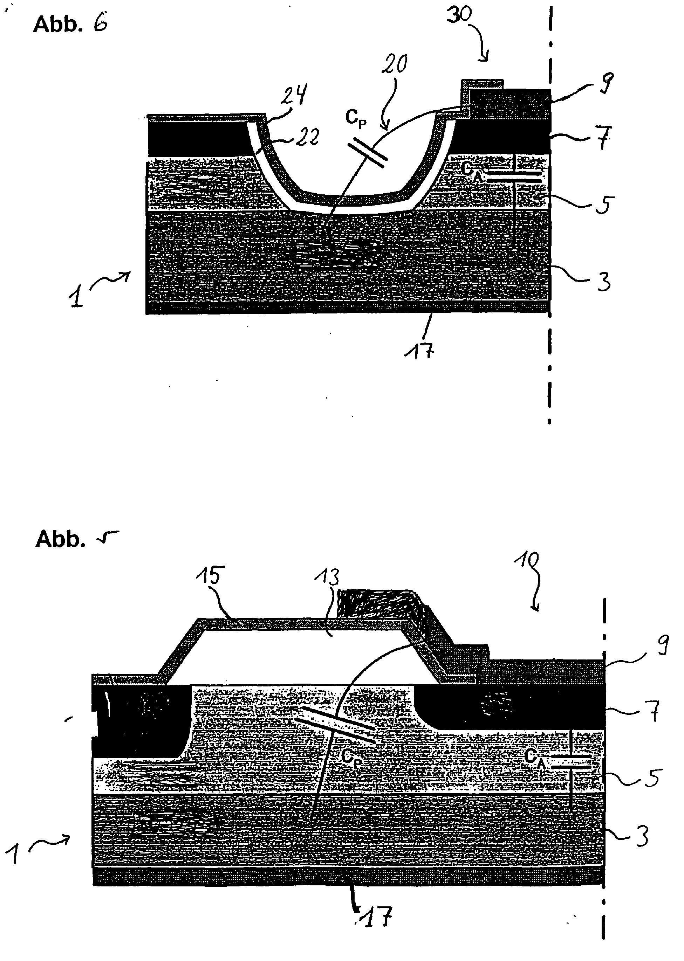

Zur Reduzierung der Randkapazität C_{P} werden für Anwendungen in der Hochfrequenztechnik häufig sogenannte Mesa-Dioden eingesetzt. Fig. 6 zeigt einen Querschnitt durch eine rotationssymmetrische Mesa-PIN-Diode. Dabei ist die Randkapazität C_{P} bedingt durch die Mesa-Struktur im Vergleich zu der in Fig. 5 gezeigten Diode deutlich verringert, da in dem Graben 20 Luft als Dielektrikum vorgegeben ist, die eine niedrige Dielektrizitätskonstante (ε=1) aufweist. Der Graben ist durch eine Grabenoxidschicht 22 und ein darauf liegendes Nitridschicht 24 abgedeckt, so daß die Siliziumoberfläche im Graben passiviert ist. Die Sperrkapazität der Diode liegt typischerweise unterhalb von 400 fF.

Mit Mesa-PIN-Dioden gelingt es bei gleichem Widerstand in Flußrichtung ca. 15% kleinere Kapazitäten in Sperrichtung zu realisieren, als dies mit einer planaren Diode möglich ist. Ein weiterer Vorteil einer Mesa-PIN-Diode liegt in der kürzeren Abschaltzeit. Dies ist darauf zurückzuführen, daß durch die laterale Eingrenzung der Ladungsträger beim Abschalten keine Ladungen aus dem Randbereich der Diode zu entfernen sind, wie das bei einer planaren Diode der Fall ist.

Die in Fig. 6 gezeigte Diode besitzt jedoch den Nachteil, daß bei gegebener Dicke des intrinsischen Gebiets die Sperrschichtkapazität durch die für die Kontaktierung erforderliche Größe der Elektrode 9 nach unten begrenzt ist. Die Fläche der Elektrode 9 kann nicht beliebig verkleinert werden, da später auf dieser Fläche ein Bonddraht oder eine andere Anschlußverbindung aufgebracht werden muß, welche die Diode z.B. mit einem Gehäuse-Pin verbindet. Herkömmliche Bondverfahren benötigen eine Bondauflagefläche von etwa 10000 *µ*m² und mehr. Dies hat in der Regel zur Folge, daß man auch das Diffusionsgebiet 7 nicht verkleinern kann, da die Kontaktierungsfläche, die für eine Mikroschweißverbindung benötigt wird, eine minimale Größe beibehalten muß. Da die Größe der Elektrode 9 durch die für eine Kontaktierung benötigte Fläche, z.B. durch einen Bonddraht, vorgegeben ist, wird die Verringerung der Sperrkapazität der Diode durch diese Fläche limitiert. Weiterer Nachteil ist, daß bei kleinen Dioden und damit auch kleinen Kontaktierungsflächen z.B. ein Bondfuß eines Bonddrahtes schon bei kleinsten Fehljustierungen über die Kontaktfläche hinüberreichen und die isolierenden Schichten 22 und 24 beschädigen kann.

Der Erfindung liegt daher die Aufgabe zugrunde, eine Diode bereitzustellen, die auch bei einer vorgegebenen minimalen Bondfläche eine gewünschte d.h. möglichst kleine Sperrkapazität aufweist. Des weiteren soll die Diode das typische Schaltverhalten einer Mesa-PIN-Diode aufweisen.

Diese Aufgabe wird von der Diode gemäß dem Patentanspruch 1 gelöst. Weiterhin wird ein Verfahren zur Herstellung von Dioden nach dem Patentanspruch 15 bereitgestellt. Weitere vorteilhafte Ausführungsformen, Ausgestaltungen und Aspekte der vorliegenden Erfindung ergeben sich aus den abhängigen Patentansprüchen, der Beschreibung und den Ausführungsbeispielen.

Erfindungsgemäß wird Diode, insbesondere für Anwendungen in der Hochfrequenztechnik, bereitgestellt, welche ein Halbleitersubstrat, das ein erstes Gebiet eines ersten Leitfähigkeitstyps, ein zweites Gebiet eines zweiten Leitfähigkeitstyps und ein Verarmungsgebiet aufweist, welches zwischen dem ersten und dem zweiten Gebiet angeordnet ist, wenn die Diode in Sperrichtung betrieben wird, und zumindest eine Elektrode auf der Oberfläche des Halbleitersubstrat aufweist, die eine elektrische Verbindung zu dem ersten Gebiet herstellt. Die erfindungsgemäße Diode ist dadurch gekennzeichnet, daß zumindest ein Graben in dem Halbleitersubstrat und eine Isolation auf der Oberfläche des Halbleitersubstrats vorgesehen sind, so daß das Verarmungsgebiet durch den Graben und die Fläche, über welche die Elektrode direkt mit dem ersten Gebiet in Kontakt steht, durch die Isolation begrenzt ist.

Die erfindungsgemäße Diode besitzt den Vorteil, daß die Ausdehnung des Verarmungsgebiets, und damit die Flächenkapazität der Diode, und die Größe der Elektrode voneinander entkoppelt sind. Die laterale Ausdehnung des Verarmungsgebiets kann unabhängig von der Größe der Elektrode gewählt werden. Der Teil der Elektrode, der nicht direkt mit dem ersten Gebiet in Kontakt steht, der aber notwendig ist, um eine genügend große Fläche für einen Bonddraht zur Verfügung zu stellen, wird auf der Isolation angeordnet. Die Isolation ermöglicht es, einen Teil der Elektrode in einem ausreichendem Abstand zu dem Halbleitersubstrat zu halten, wodurch die Kapazität der Diode reduziert wird.

Daher kann die laterale Ausdehnung des Verarmungsgebiets optimal an die jeweilige Anwendung anpaßt werden, ohne daß auf Probleme, die sich aus dem Bonden der Diode ergeben können, Rücksicht genommen werden muß. Darüber hinaus weist die erfindungsgemäße Diode im wesentlichen die gleiche kleine Randkapazität wie eine Mesa-Diode auf. Der Graben im Halbleitersubstrat hilft, die Randkapazität der Elektrode zum Halbleitersubstrat zu senken, da im Randgebiet nicht Silizium mit ε=12, sondern ein Material mit einer geringeren Dielektrizitätskonstanten z.B. Siliziumoxid mit ε=4 oder Gas mit ε=1 vorgesehen sind.

Der Graben ist bevorzugt mit einem isolierenden Füllmaterial mit möglichst kleiner Dielektritätskonstante aufgefüllt. Die Füllung sowie die Isolation an der Substratoberfläche bewirken, daß z.B. der Bondfuß eines Bonddrahtes nicht in den Graben hineinragen kann und dadurch die Kapazität der Diode erhöht. Das Füllmaterial sollte bevorzugt eine Dielektrizitätskonstante haben, die kleiner als die von Silizium ist.

Bevorzugt weist die Diode eine PIN-Diodenstruktur auf, d.h. das Halbleitersubstrat, weist auf der Oberfläche ein undotiertes oder nur sehr schwach dotierte Gebiet auf. Diese sehr schwach dotierte Gebiet, das auch intrinsisches Gebiet genannt wird, ist üblicherweise durch ein eptitaktisches Verfahren auf das höher dotierte Halbleitersubstrat aufgewachsen. Bei gegebener Flächengeometrie bestimmt daher die Dicke dieser Epitaxie-Schicht weitgehend die Kapazität der Diode.

Bevorzugtes Füllmaterial für den Graben ist Siliziumoxid. In einer bevorzugten Ausführung wird insbesondere ein BPSG-Oxid für die Füllung des Grabens verwendet. Gemäß einer weiteren bevorzugten Ausführungsform werden vor der Füllung Grabenboden und Grabenwand mit einer Schicht aus undotiertem Silikatglas abgedeckt, um die Flächenzustandsdichte an der Grabenoberfläche so gering wie möglich zu halten.

Bevorzugt ist im Graben ein Hohlraum vorgesehen. Ein Hohlraum führt zu einer weiteren Reduzierung der Randkapazität, da die Dielektrizitätskonstante von Gas (Luft) mit ε=1 deutlich geringer als die von Siliziumoxid ist.

Bevorzugt werden der oder die Hohlräume im isolierenden Füllmaterial dadurch hergestellt, daß der Hohlraum durch eine nicht konforme Abscheidung aufgefüllt wird. Bei einer derartigen Abscheidung kommt es zu einer sogenannten "Lunkerbildung", da sich aufgrund überhöhter Ablagerung am oberen Grabenrand der Graben nicht vollständig auffüllen läßt.

Bevorzugt enthält die Elektrode Aluminium, da sich mit diesem Material ein guter ohmscher Kontakt auf Silizium realisieren läßt, und Aluminium gut für die Kontaktierung mit Bonddrähten aus Gold oder Aluminium geeignet ist. Weiterhin ist es bevorzugt, wenn mehr als 20%, bevorzugt mehr als 40%, der Elektrode über der Isolation angeordnet sind.

Weiterhin wird ein Verfahren zur Herstellung einer Diode mit den folgenden Schritten bereitgestellt:
a) ein Halbleitersubstrat, das ein erstes Gebiet eines ersten Leitfähigkeitstyps, ein zweites Gebiet eines zweiten Leitfähigkeitstyps und ein Verarmungsgebiet aufweist, welches zwischen dem ersten und dem zweiten Gebiet angeordnet ist, wenn die Diode in Sperrichtung betrieben wird, wird bereitgestellt;
b) zumindest ein Graben, der das Verarmungsgebiet begrenzt, wird erzeugt;
c) der Graben wird mit isolierendem Füllmaterial gefüllt;
d) eine Isolation wird auf der Oberfläche des Halbleitersubstrats erzeugt;
e) eine Elektrode wird auf der Oberfläche des Halbleitersubstrats erzeugt, wobei die Elektrode eine elektrische Verbindung zu dem ersten Gebiet herstellt und die Fläche, über welche die Elektrode direkt mit dem ersten Gebiet in Kontakt steht, durch die Isolation begrenzt ist.

Die Erfindung wird nachfolgend anhand von Figuren der Zeichnung näher dargestellt. Es zeigen:
- Fig. 1: einen Querschnitt durch eine erfindungsgemäße rotationssymmetrische PIN-Diode,
- Fig. 2: einen Querschnitt durch eine weitere erfin- dungsgemäße Ausführungsform einer rotations- symmetrischen PIN-Diode,
- Fig. 3: einen Querschnitt durch eine dritte erfin- dungsgemäße Ausführungsform einer rotations- symmetrischen PIN-Diode mit Graben und Wall sowie einem Hohlraum, wobei der Graben mit einem BPSG-Oxid gefüllt ist,
- Fig. 4A, 4B: die Abschaltcharakteristik einer herkömmli- chen planaren Diode im Vergleich zu der Ab- schaltcharakteristik einer erfindungsgemäßen Diode,
- Fig. 5: einen Querschnitt durch eine rotations- symmetrische PIN-Diode nach dem Stand der Technik,
- Fig. 6: einen Querschnitt durch eine rotations- symmetrische Mesa-PIN-Diode nach dem Stand der Technik.

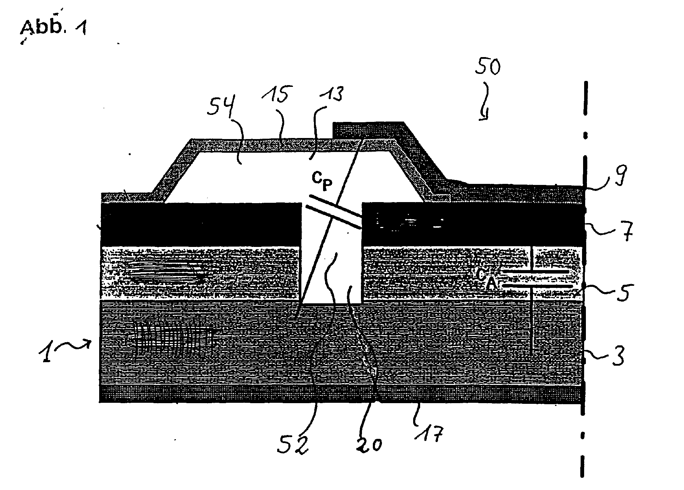

Fig. 1 zeigt einen Querschnitt durch eine erste Ausführungsform der vorliegenden Erfindung. Die erfindungsgemäße PIN-Diode 50 weist ein hoch dotiertes n-leitendes Siliziumsubstrat 3 (n-leitendes Gebiet) auf. Auf diesem n-leitenden Siliziumsubstrat 3 ist ein gering dotiertes n-leitendes Gebiet 5 (intrinsisches Gebiet) angeordnet. Im vorliegenden Beispiel wurde das intrinsische Gebiet 5 durch ein Epitaxie-Verfahren erzeugt. In dem intrinsischen Gebiet 5 bildet sich das Verarmungsgebiet aus, wenn die PIN-Diode in Sperrichtung betrieben wird. Über intrinsischen Gebiet 5 ist hoch dotiertes p-leitendes Gebiet 7 angeordnet. Das p-leitende Gebiet 7 wurde erzeugt, indem Bor in den oberen Bereich der Epitaxie-Schicht implantiert und anschließend durch eine Wärmebehandlung ausdiffundiert wurde.

Ausgehend von der Oberfläche des p-leitenden Gebiets 7 reicht ein Graben 20, der durch eine anisotrope Ätzung erzeugt wurde, bis in das n-leitende Siliziumsubstrat 3. Der Graben 20 begrenzt die laterale Ausdehnung des Verarmungsgebiets, wenn die PIN-Diode in Sperrichtung betrieben wird. Gleichzeitig bildet der Graben 20 eine Barriere für die in das intrinsische Gebiet 5 injizierten Ladungsträger, wenn die PIN-Diode in Durchlaßrichtung betrieben wird. Im vorliegenden Beispiel beträgt die Breite des Grabens etwa 1,6 µm. Die Tiefe des Grabens ist von der Dicke der Epitaxie-Schicht abhängig und beträgt im vorliegenden Beispiel 6 µm.

Der Graben 20 ist mit einem Oxid, das eine niedrige Dielektrizitätskonstante (ε=4) aufweist, gefüllt. Im vorliegenden Beispiel wurde der Graben durch ein PECVD-Oxid gefüllt. Dazu wurde die Oxidschicht konform bis zu einer Dicke von etwa 6 µm auf der Epitaxie-Schicht abgeschieden. Durch die konforme Abscheidung wurde der Graben nahezu vollständig aufgefüllt. Gleichzeitig ergibt sich eine nahezu planare Oxid-Oberfläche. Anschließend wurde das Oxid mit strukturiert. Danach wurde eine Siliziumnitridschicht 15 abgeschieden und ebenfalls strukturiert, womit eine Passivierung auf der Oberfläche der Diode erzeugt wurde.

Anschließend wurde auf der Vorderseite eine Aluminiumelektrode 9 erzeugt. Die zum späteren Bonden der Diode notwendige Elektrodenfläche wird dabei dadurch bereitgestellt, daß ein großer Teil der Elektrode über der Isolation 13 (mehr als 60%) angeordnet ist und nur ein geringer Teil der Elektrode 9 direkt mit dem p-leitenden Gebiet 7 verbunden ist. Schließlich wird das Siliziumsubstrat 3 durch Schleifen gedünnt und ein Rückseitenkontakt 17 aufgebracht. Im vorliegenden Beispiel wurde dazu eine Gold/Arsen-Legierung auf die Rückseite des Siliziumsubstrats 3 aufgebracht.

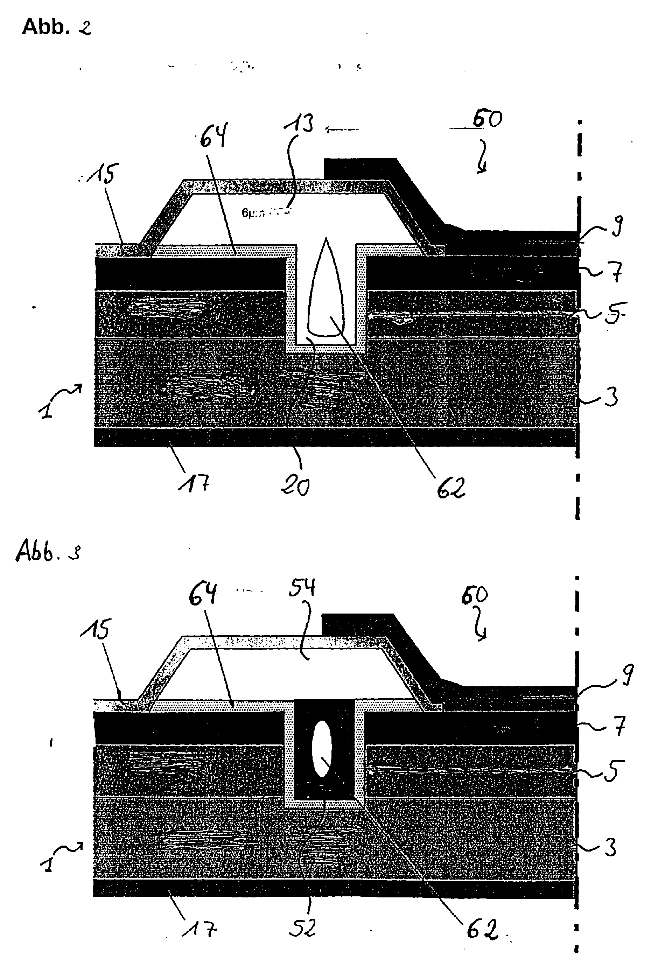

Fig. 2 zeigt einen Querschnitt durch eine weitere Ausführungsform der vorliegenden Erfindung. Die Diode ist im wesentlichen wie die in Fig. 1 gezeigte Diode aufgebaut, jedoch wurde der Graben 20 auf unterschiedliche Weise aufgefüllt. Vor dem Aufbringen einer PECVD-Oxidschicht wurde der Graben 20 und die Halbleitersubstratfläche mit einer undotierten Silikatglas-Schicht 64 abgedeckt, um die Oberflächenzustandsdichte an der Grabenwand zu minimieren. Nachfolgend wurde die PECVD-Oxidschicht bis zu einer Dicke von etwa 6 µm durch eine nicht-konforme CVD Abscheidung erzeugt. Bei einer derartigen Abscheidung kommt es zu einer sogenannten "Lunkerbildung", da sich aufgrund überhöhter Ablagerung am oberen Grabenrand der Graben nicht vollständig auffüllen läßt. Dadurch wurde in dem Graben 20 ein Hohlraum 62 erzeugt. Gleichzeitig ergibt sich wiederum eine nahezu planare Oxid-Oberfläche. Anschließend wurde das Oxid mit strukturiert. Danach wurde eine Siliziumnitridschicht 15 abgeschieden und ebenfalls strukturiert, womit eine Passivierung auf der Oberfläche der Diode erzeugt wurde.

Der Hohlraum 62 hilft, die Randkapazität der Diode weiter zu senken, da das Gas im Hohlraum mit einer Dielektrizitätkonstante von etwa ε=1 eine deutlich geringere Dielektrizitätkonstante als das umgebende Siliziumoxid aufweist. Die Prozeßparameter wurden dabei so gewählt, daß der Hohlraum mehr als 40% des Volumens im Graben einnimmt.

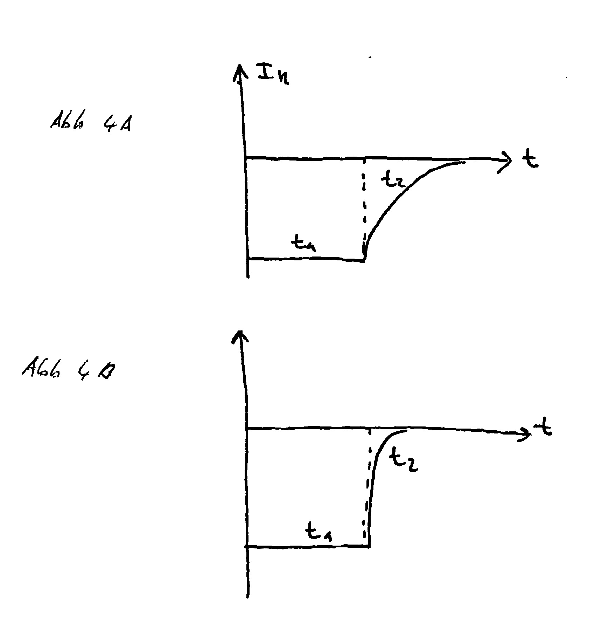

Fig. 3 zeigt einen Querschnitt durch eine weitere Ausführungsform der vorliegenden Erfindung. Sie unterscheidet sich von der in Fig. 2 dargestellten Ausführungsform dadurch, daß der Graben 20 mit einem anderen Oxid aufgefüllt wurde. Bei der in Fig. 3 gezeigten Ausführungsform wurde der Graben mit einem BPSG-Oxid 52 gefüllt. Dazu wurde eine BPSG-Oxidschicht abgeschieden, welche durch Verfließen planarisiert wurde. Nachfolgend wurde die BPSG-Oxidschicht durch ein Ätzverfahren zurückgeätzt, wobei der Graben 20 bis auf den Hohlraum 62 verschlossen wurde. Nachfolgend wurde wiederum eine PECVD-Oxidschicht abgeschieden und strukturiert, so daß über dem Graben 20 eine Isolation 13 gebildet wurde. Mit Hilfe der Siliziumnitridschicht 15 wurde anschließend die Passivierung erzeugt.

Mit diesem Aufbau gelingt es, beispielsweise eine runde Diode herzustellen, deren Verarmungsgebiet einen Radius von etwa 60 *µ*m aufweist, wobei die zum Bonden benötigte Elektrode einen Radius von 110 *µ*m aufweist. Die große Elektrodenfläche ermöglicht eine problemlose Montage eines Bonddrahtes, ohne daß die Sperrkapazität dabei beeinträchtigt wird. Bisherige MESA-PIN-Dioden weisen hingegen ein Verarmungsgebiet mit einem minimalen Radius von etwa 70 *µ*m auf. Eine weitere Verkleinerung des Verarmungsgebiets ist bei diesen Dioden nicht möglich.

Die Figuren 4A und 4B zeigen den sich ergebende Zeitverlauf des Stromes, wenn eine herkömmliche, planare PIN-Diode (4A) bzw eine erfindungsgemäße Diode (4B) über einen Widerstand entladen bzw. abgeschaltet wird. Man erkannt, daß diese Abschaltcharakteristik in zwei Zeiträume t1 und t2 eingeteilt ist. Innerhalb des Zeitraums t1 ist der Strom nahezu konstant. Dieser Zeitraum ist dadurch gekennzeichnet, daß die Ladungsträgerkonzentration am Rand der intrinsischen Zone zu den hochdotierten Anschlüssen hin immer noch höher als die intrinsische Konzentration ist. Die Zeit t1 ist im wesentlichen abhängig von der in die intrinsische Zone injizierten Ladung und dem Entladestrom.

Im Zeitraum t2 klingt der Strom ab. Physikalisch ist dieser Zeitraum durch Diffusion und Rekombination in der intrinsischen Zone dominiert. Die Zeit t2 hängt von der Größe der Oberfläche des Injektionsgebiets bezüglich den hochdotierten Anschlüssen ab. Diese Oberfläche ist bei der erfindungsgemäßen Diode durch laterale Eingrenzung der Ladungsträger deutlich kleiner. Dementsprechend klingt der Entladestrom bei der erfindungsgemäßen Diode deutlich schneller ab als dies bei einer herkömmlichen planaren PIN-Diode der Fall ist. Da die Zeit t1 vom Entladestrom abhängt, die Zeit t2 hingegen praktisch unabhängig von der Elektrodenspannung ist, werden mit der erfindungsgemäßen Diode steilere Abschaltflanken erreicht. Die Abschaltcharakteristik der erfindungsgemäßen Diode entspricht somit im wesentlichen der Abschaltcharakteristik einer Mesa-PIN-Diode.

## Patentansprüche

1. Diode, insbesondere für Anwendungen in der Hochfrequenztechnik, mit einem Halbleitersubstrat, das ein erstes Gebiet eines ersten Leitfähigkeitstyps, ein zweites Gebiet eines zweiten Leitfähigkeitstyps und ein Verarmungsgebiet aufweist, welches zwischen dem ersten und dem zweiten Gebiet angeordnet ist, wenn die Diode in Sperrichtung betrieben wird, und zumindest einer Elektrode auf der Oberfläche des Halbleitersubstrat, die eine elektrische Verbindung zu dem ersten Gebiet herstellt,
**dadurch gekennzeichnet, daß** zumindest ein Graben in dem Halbleitersubstrat und eine Isolation auf der Oberfläche des Halbleitersubstrats vorgesehen sind, so daß das Verarmungsgebiet durch den Graben und die Fläche, über welche die Elektrode direkt mit dem ersten Gebiet in Kontakt steht, durch die Isolation begrenzt ist.

2. Diode nach Anspruch 1,
**dadurch gekennzeichnet, daß**
die Diode ein intrinsisches Gebiet zwischen dem ersten und dem zweiten Gebiet aufweist.

3. Diode nach Anspruch 1 oder 2,
**dadurch gekennzeichnet, daß**
die Isolation über dem Graben angeordnet ist.

4. Diode nach einem der vorhergehenden Ansprüche,
**dadurch gekennzeichnet, daß**
das der Graben teilweise mit einem isolierenden Füllmaterial aufgefüllt ist.

5. Diode nach Anspruch 4,
**dadurch gekennzeichnet, daß**
das isolierende Füllmaterial ein BPSG-Oxid ist.

6. Diode nach Anspruch 4,
**dadurch gekennzeichnet, daß** das isolierende Füllmaterial ein PECVD-Oxid ist.

7. Diode nach einem der vorhergehenden Ansprüche,
**dadurch gekennzeichnet, daß** Grabenboden und Grabenwände durch eine undotierte Silikatglas-Schicht abgedeckt sind.

8. Diode nach einem der vorhergehenden Ansprüche,
**dadurch gekennzeichnet, daß** das der Graben mindestens einen Hohlraum aufweist.

9. Diode nach einem der vorhergehenden Ansprüche,
**dadurch gekennzeichnet, daß**
das Material der Isolation gleich dem Füllmaterial ist.

10. Diode nach einem der vorhergehenden Ansprüche,
**dadurch gekennzeichnet, daß**
die Isolation aus einem PECVD-Oxid besteht.

11. Diode nach einem der vorhergehenden Ansprüche,
**dadurch gekennzeichnet, daß**
die Elektrode aus Aluminium besteht.

12. Diode nach einem der vorhergehenden Ansprüche,
**dadurch gekennzeichnet, daß**
mehr als 20%, bevorzugt mehr als 40%, der Elektrode über der Isolation angeordnet sind.

13. Diode nach einem der vorhergehenden Ansprüche,
**dadurch gekennzeichnet, daß**
eine zweite Elektrode an der Rückseite des Halbleitersubstrats angeordnet ist.

14. Diode nach einem der vorhergehenden Ansprüche,
**dadurch gekennzeichnet, daß**
die Rückseite des Halbleitersubstrats gedünnt ist.

15. Verfahren zur Herstellung einer Diode, insbesondere für Anwendungen in der Hochfrequenztechnik, mit den folgenden Schritten:
a) ein Halbleitersubstrat, das ein erstes Gebiet eines ersten Leitfähigkeitstyps, ein zweites Gebiet eines zweiten Leitfähigkeitstyps und ein Verarmungsgebiet aufweist, welches zwischen dem ersten und dem zweiten Gebiet angeordnet ist, wenn die Diode in Sperrichtung betrieben wird, wird bereitgestellt;
b) zumindest ein Graben, der das Verarmungsgebiet begrenzt, wird erzeugt;
c) der Graben wird mit isolierendem Füllmaterial gefüllt;
d) eine Isolation wird auf der Oberfläche des Halbleitersubstrats erzeugt;
e) eine Elektrode wird auf der Oberfläche des Halbleitersubstrats erzeugt, wobei die Elektrode eine elektrische Verbindung zu dem ersten Gebiet herstellt und die Fläche, über welche die Elektrode direkt mit dem ersten Gebiet in Kontakt steht, durch die Isolation begrenzt ist.

16. Verfahren nach Anspruch 15,
**dadurch gekennzeichnet, daß**
ein Halbleitersubstrat mit einem intrinsischem Gebiet bereitgestellt wird.

17. Verfahren nach Anspruch 15 oder 16,
**dadurch gekennzeichnet, daß**
der Graben durch eine anisotrope Ätzung erzeugt wird.

18. Verfahren nach einem der Ansprüche 15 bis 17,
**dadurch gekennzeichnet, daß** Grabenboden und Grabenwände mit einer undotierte Silikatglas-Schicht beschichtet werden.

19. Verfahren nach einem der Ansprüche 15 bis 18,
**dadurch gekennzeichnet, daß**
das der Graben durch eine nicht konforme Siliziumoxidabscheidung gefüllt wird, so daß sich in dem Graben ein Hohlraum bildet.

20. Verfahren nach Anspruch 19,
**dadurch gekennzeichnet, daß**
das Siliziumoxid durch einen BPSG-Prozeß aufgebracht wird.

21. Verfahren nach einem der Ansprüche 15 bis 20,
**dadurch gekennzeichnet, daß**
das der Graben gefüllt und die Isolation erzeugt wird, indem eine Siliziumoxidschicht abgeschieden und anschließend strukturiert wird.

22. Verfahren nach einem der Ansprüche 15 bis 21,
**dadurch gekennzeichnet, daß**
das die Isolation in Form eines Trapez strukturiert wird.

23. Verfahren nach einem der Ansprüche 15 bis 22
**dadurch gekennzeichnet, daß**
die Rückseite des Halbleitersubstrats gedünnt wird.

24. Verfahren nach einem der Ansprüche 15 bis 23
**dadurch gekennzeichnet, daß**
auf der Rückseite der Diode ein zweiter Kontakt angebracht wird.
